# EUROPEAN PATENT APPLICATION

(11) **EP 2 362 459 A1**
(43) Date of publication of application: **31.08.2011**
(21) Application number: 10154545.7
(22) Date of filing: 24.02.2010
(51) Int. Cl.: H01L 51/00, G01N 27/414, H01L 29/16, H01L 29/786

(54) **Modified graphene structure and method of manufacture thereof**

(71) Applicant: University College Cork-National University of Ireland, Cork, Cork (IE); AMO GMBH, 52074 Aachen (DE)
(72) Inventor: Quinn, Aidan, Cork (IE); Long, Brenda, County Limerick (IE); Manning, Mary, County Cork (IE); Szafranek, Bartholomäus, Aachen (DE)
(74) Representative: Hally, Anna-Louise

(57) **Abstract**

The present invention is directed to a modified graphene structure comprising at least one graphene sheet (1) and a self-assembled monolayer (2) of functional organic molecules (3) non-covalently bonded to the top and/or bottom basal planes of the graphene sheet and methods of manufacture thereof. The present invention is also directed to devices comprising the modified graphene structures, including but not limited to field-effect devices and biosensors, and to methods using the modified graphene structures.

## Description

The present invention is directed to a modified graphene structure and methods of manufacture thereof. The present invention is also directed to devices comprising the modified graphene structures, including but not limited to field-effect devices and biosensors and methods using the modified graphene structures.

### Background to the Invention

Monolayer graphene is a single layer of carbon atoms arranged in a two-dimensional (2D) honeycomb-like lattice, and is a basic building block for carbon materials of other dimensionalities, including fullerenes, nanotubes, few-layer graphene (≤ 10 layers) or 3D graphite.

In 2004 a method for the micromechanical exfoliation of few-layer graphene from graphite and fabrication of back-gated graphene field-effect devices was reported (Novoselov et al., "Electric field effect in atomically thin carbon films" Science, 2004, 306, 666). Methods for large area preparation of graphene have also been reported including thermal decomposition of silicon carbide (Berger et al., Ultrathin epitaxial graphite: 2D electron gas properties and a route towards graphene based nanoelectronic devices" J. Phys. Chem B, 2004, 108, 19912) and chemical vapour deposition (Kim et al., "Large-scale pattern growth of graphene films for stretchable transparent electrodes", Nature, 2009, 457, 706; Reina et al., "Large-area, few layer graphene films on arbitrary surfaces by chemical vapour deposition", Nano Lett, 2009, 9, 5087).

It has been identified that graphene is chemically inert which is a hugely beneficial property for device applications. However, graphene is susceptible to adsorption of ambient matter (*e.g.* oxygen and water) which can introduce an inherent instability in graphene field effect devices. A number of papers have been published pertaining to the use of graphene as a sensor (*e.g.* Schedin et al. "Detection of individual gas molecules adsorbed on graphene" Nat. Mater., 2007, 6, 652). These papers describe the adsorption of different molecules onto graphene field-effect devices, including NH₂, NO₂, H₂O, CO and the change in resistance of field-effect devices following exposure to these molecules in the gas phase.

Fabrication and characterisation of top-gated graphene field-effect devices has also been reported by a number of groups. In particular, Avouris and co-workers have reported on the fabrication of graphene field-effect devices, where the exposed surface of a graphene sheet deposited on a silicon oxide substrate is first covered by spin-coating an ultrathin polymer "buffer" dielectric (~10 nm thick) followed by deposition of an inorganic dielectric (HfO₂) by atomic layer deposition (Farmer DB et al. "Utilization of a Buffered Dielectric to Achieve High Field-Effect Carrier Mobility in Graphene Transistors" Nano Letters 2009, 9, 4474).

Das B et al ("Changes in the electronic structure and properties of graphene induced by molecular charge-transfer" Chem. Commun., 2008, 5155) discuss the interaction of an amine-substituted benzene ring with reduced graphene oxide. They describe the use of chemically exfoliated graphene (produced by chemically oxidising graphite and reducing this product to graphene) that has a high density of defects as evidenced by a reported visible defect peak (D peak, centred close to 1382 cm⁻¹) in Raman spectroscopy. They mix a stoichiometric excess of amine molecule with an amount of reduced graphene oxide and examine in the bulk the Raman signature of this product. Their Raman results indicate shifts (and broadening) in the G peak that they attribute to the interaction of the amine-substituted benzene ring with the graphene. The use of chemically exfoliated graphene is undesirable due to the high density of defects mentioned above.

Romero HE et al ("Adsorption of ammonia on graphene" Nanotechnlogy, 2009, 20, 245501) describes the adsorption/desorption of ammonia on graphene. The molecules are attached by exposing a graphene field-effect device to a vapour of ammonia in a vacuum. They use resistance measurements to determine the presence of ammonia molecules, where they find a shift in the minimum conductivity point (Dirac point) towards negative gate voltages upon the adsorption of the molecules consistent with a charge transfer.

Wang and Hersam ("Room temperature molecular-resolution characterization of self-assembled organic monolayers on epitaxial graphene" Nature Chemistry, 2009, 1, 206) discusses the formation for self-assembled monolayers of perylene-3,4,9,10-tetracarboxylic dianhydride (PTCDA) on epitaxial graphene. The graphene was prepared by annealing an n-type 6H-SiC(0001) substrate at high temperature (up to 1250°C). Once this was cooled to room temperature the PTCDA was then coated onto the graphene by resistively heating an aluminum coated tungsten boat containing the molecule under ultra-high vacuum. Once the monolayers were created they were characterized by scanning tunneling microscopy (STM) and scanning tunneling spectroscopy (STS). The STM measurements showed that these planar molecules self-assembled in a herringbone-like structure. This paper proposes three stabilising interactions: Hydrogen bonding and quadrupolar interactions between the molecules are the primary stabilising features while there is a weak π-π* interaction between the graphene and the molecule. The STS measurements indicated that the monolayer was largely electronically decoupled from the graphene.

Thus, it is well known that graphene has many potential applications (e.g. field-effect devices) in many different fields, however, graphene is susceptible to adsorption of ambient matter (*e.g.* oxygen and water) which can introduce an inherent instability in graphene field effect devices. The present invention is directed to overcoming this problem and aims to provide modified graphene structures with improved properties.

### Statements of the Invention

According to a first aspect of the invention, there is provided a stable modified graphene structure comprising a graphene sheet (1) and a self-assembled monolayer (2) of functional organic molecules (3) non-covalently bonded to the top and/or bottom basal planes of the graphene sheet wherein each functional organic molecule (3) comprises
an anchor group (4) which forms a non-covalent bond with the graphene;
a functional group (6); and
an alkyl-chain spacer group (5) which separates the anchor group (4) and functional group (6) and facilitates the self-assembly and stabilisation of the monolayer (2).

According to a second aspect of the invention, there is provided a method for the manufacture of a graphene structure according to any of the preceding claims comprising
i) preparing and cleaning a substrate (7);
ii) depositing a layer of graphene (1) onto the substrate (7);
iii) reacting the substrate (7) from step (ii) with a functional organic molecule (3) comprising
   an anchor group (4) which has the ability to form a non-covalent bond with graphene,
   a functional group (6); and
   an alkyl-chain spacer group which separates the anchor group (4) and functional group (6) and facilitates the formation of a self-assembled monolayer (2) of functional organic molecules (3);
to result in the formation of a self-assembled monolayer (2) of one or more functional organic molecules (3) non-covalently bonded to the top and/or bottom basal plane of the graphene.

According to a third aspect of the invention, there is provided a method for directed deposition of graphene onto a substrate (7) comprising patterning, either by photolithography or by soft lithography, the self-assembled monolayer (2) of functional organic molecules (3) to result in pre-defined areas on the substrate (7) to enable the site-specific deposition of graphene (1) at the pre-defined areas on the substrate (7) in step (iii).

According to a fourth aspect of the invention, there is provided a method for the gas and/or liquid-phase sensing of target chemical or biological groups in a sample solution or vapour, comprising the steps of
i) selecting a target moiety (11);
ii) modifying the functional head group (6, 6B) of a graphene structure (1) of the invention to selectively bind the target moiety (11);
iii) placing the modified graphene structure (1) of step (ii) in a biosensor
iv) exposing the biosensor to a sample solution or vapour; and
v) monitoring and/or recording the selective binding of the target moiety (11) to the functional head group (6, 6B) of the graphene structure (1).

### Description of Invention

According to a first aspect of the invention, there is provided a stable modified graphene structure comprising a graphene sheet and a self-assembled monolayer of functional organic molecules non-covalently bonded to the top and/or bottom basal planes of the graphene sheet wherein each functional organic molecule comprises an anchor group which forms a non-covalent bond with the graphene; a functional group; and an alkyl-chain spacer group which separates the anchor group and functional group and facilitates the self-assembly and stabilisation of the monolayer.

The use of the functional organic molecules of the invention which comprise an anchor group, functional group and a spacer group provides for a stable modified graphene structure. We have found that graphene is extensively covered with the functional organic molecules of the invention. This dense coverage along with spacer groups which can interact with each other results in a monolayer which is inherently stable. We postulate that this stabilisation is the result of a van der Waals interaction between the spacer groups, preferably alkyl chains, attached to the anchor groups. Preliminary results from quantum chemistry modelling of an methylamine molecule on pyrene using second-order, many-body perturbation theory suggest that the amine anchor group non-covalently interacts with the graphene surface with a binding energy on the order of 220 meV. Preliminary results from atomistic molecular dynamics simulations on assemblies of aminodecane molecules on graphene indicate formation of a self-assembled monolayer with mean nearest-neighbour separations of the amine anchor groups on the order of 0.33 nm.

The present invention involves the non-covalent attachment of functional organic molecules to the top and/or bottom and/or edges of graphene sheets. The molecular functionalisation process of the invention is non-covalent and advantageously does not have a detrimental effect on the electronic properties of graphene. This is in contrast to covalent functionalisation where adsorbed contaminants can destabilise the current-(gate)voltage characteristics of graphene field-effect devices, leading to hysteretic behaviour and poor stability over time.

We have advantageously found that the non-covalent attachment of functional organic molecules to the top and/or bottom and/or edges of graphene sheets can
- passivate the surface of graphene, by reducing the adsorption of ambient matter contaminants or water, and advantageously increasing the stability of the graphene.
- introduce new functionality to graphene to result in new applications for graphene. For example, the modified graphene of the invention may be used in molecular recognition to promote binding of specific moieties for chemo- or bio-sensing applications, either as conductivity-based sensors, resonators (mass sensors) or electrochemical sensors. Thus, there is significant potential to introduce further functionality to the graphene.
- allow for adsorbate doping / manipulation of electronic properties: For graphene contacted with metal microelectrodes (field-effect devices), a clear stabilisation of the /_{d}-V₉ characteristics over a period of months has been observed. Evidence of n-type doping has been observed upon treatment with amine-bearing molecules, suggesting adsorbate doping. This route may open up possibilities for manipulation of the charge transport characteristics of graphene devices, e.g. for sensing applications.
- open a route towards directed deposition of graphene. Known methods for the deposition of graphene include mechanical exfoliation which is an inefficient method for production of graphene across large areas (e.g. mm² to cm²). Other routes for production of graphene include chemical vapour deposition onto metal catalyst layers. The present invention involves the functionalisation of a substrate surface with functional organic molecules which bear groups to which the graphene can bind (e.g., diaminodecane molecules on SiO₂). Directed deposition can be achieved by patterning of the molecules, either by photolithography or by soft lithography methods (such as microcontact printing), followed by deposition of graphene, e.g., by mechanical exfoliation from graphite or by transfer of a graphene layer deposited or grown on another substrate.

Ideally, the graphene sheet has a thickness between 1 and 10 atomic layers and critical lateral dimensions from 5 nm (nanoribbons) to 40 µm. Alternative dimensions may be chosen. For example, exfoliated graphene flakes greater than 100 µm in length/width may be utilised.

According to a preferred embodiment of this aspect of the invention, the graphene structure is deposited on a substrate (7), preferably a silicon/silicon oxide substrate. According to a preferred embodiment of the invention, the substrate comprises crystalline silicon. Preferably, the crystalline silicon has been thermally oxidised to a thickness of 90 nanometres.

Optionally, the top layer of the substrate is formed from silicon oxide, silicon, gold, silver, aluminium, aluminium oxide, silicon nitride, titanium, titanium oxide, indium tin oxide (ITO), glass or quartz.

It will be understood that the graphene structure of the invention may be a suspended structure, for example a graphene sheet which covers or partly covers a recessed region on a substrate. This recessed region could be a trench or pit etched into a substrate. Ultrahigh electron mobility has been reported in suspended graphene structures (Bolotin, KI et al., "Ultrahigh electron mobility in suspended graphene", Solid State Communications 2008, 146, 351). Several groups have also reported on the use of suspended graphene sheets as electromechanical resonators (Bunch JS et al., "Electromechanical resonators from graphene sheets" Science 2007, 315, 490; Chen C et al., "Performance of monolayer graphene nanomechanical resonators with electrical readout" Nature Nanotechnology, 2009, 4, 861). Several structural forms may be considered here, comprising a graphene sheet clamped either on one side (a cantilever), on two unconnected sides (a beam) or on all sides (a membrane).

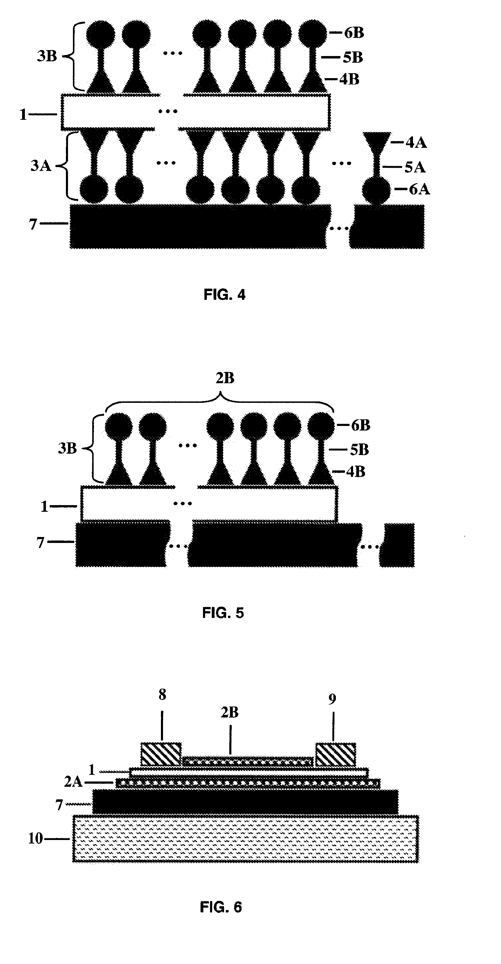

According to another embodiment of this aspect of the invention, the graphene structure comprises a first layer of functional organic molecules (3) non-covalently bound to the bottom basal plane of the graphene and a second layer of functional organic molecules (3) non-covalently bound to the top basal planes of the graphene; wherein the first layer of functional organic molecules (3A) promotes binding to a substrate material (7) and can provide adsorbate doping via charge transfer, and the second layer of functional organic molecules (3B) provides additional functionality. This is shown in the embodiment of FIG. 4. In this embodiment, the additional functionality provided by the second layer of functional organic molecules (3B) includes surface passivation and/or adsorbate doping.

According yet another embodiment of this aspect of the invention, the alkyl-chain spacer group comprises not less than 6 carbon atoms and not more than 18 carbon atoms. The alkyl chain contributes to the stabilisation of the monolayer as they can interact with each to result in a 3-D monolayer which is inherently stable. This stabilisation is the result of a van der Waals interaction between the spacer groups.

It will be understood that the anchor group must interact with the graphene to result in the formation of a non-covalent bond, by one or more of the following interactions: hydrogen bonding, ionic and/or hydrophobic forces. According to another embodiment of this aspect of the invention the anchor group is selected from an amine, alcohol, aniline, para-deriviative of aniline, carboxylic acid, thiol, halide, pyridine, nitro, nitrile group or a derivative thereof.

According to yet another embodiment of this aspect of the invention, the functional group is selected from a methyl, an amine, a thiol, a hydroxy, a carboxylic acid, a nitro group, a silane or a derivative thereof.

Optionally, the functional group may be chosen to interact with a target moiety. The target moiety may be a nanocrystal; a biomolecule; or an ion. The biomolecule may be a nucleic acid (Ribonucleic acid (RNA), Deoxyribonucleic acid (DNA)), oligonucleotide, polymerase chain reaction (PCR) product, amino acid, antibody, antibody fragment, antigen, aptamer, enzyme, peptide, protein or a fragment thereof.

In one embodiment, the functional group interacts directly with the target moiety.

In another embodiment, the functional group interacts indirectly with the target moiety through a bridging group. For example, the bridging group may be phenylenedisothiocyanate (PDITC). PDITC is known to interact with DNA.

According to a preferred embodiment of the invention, the functional organic molecule is an amine-terminated molecule.

The graphene structure of the invention may be used in other field-effect devices or electromechanical devices, including sensors such as chemo- or bio-sensing applications.

Such field-effect devices include back-gated field effect devices and top-gated field effect devices.

Accordingly, in one embodiment, there is provided a back-gated field-effect device comprising the graphene structure (1) of the invention wherein the top basal plane of the graphene structure (1) is electrically contacted by separate source (8) and drain (9) electrodes, the graphene structure (1) is located over a gate dielectric (7), which is electrically contacted by a gate electrode (10) such that the exposed regions of the top basal plane are functionalised with a layer of molecules (2B) and optionally comprise a layer of molecules (2A), which promotes binding of the graphene structure (1) to the gate dielectric (7).

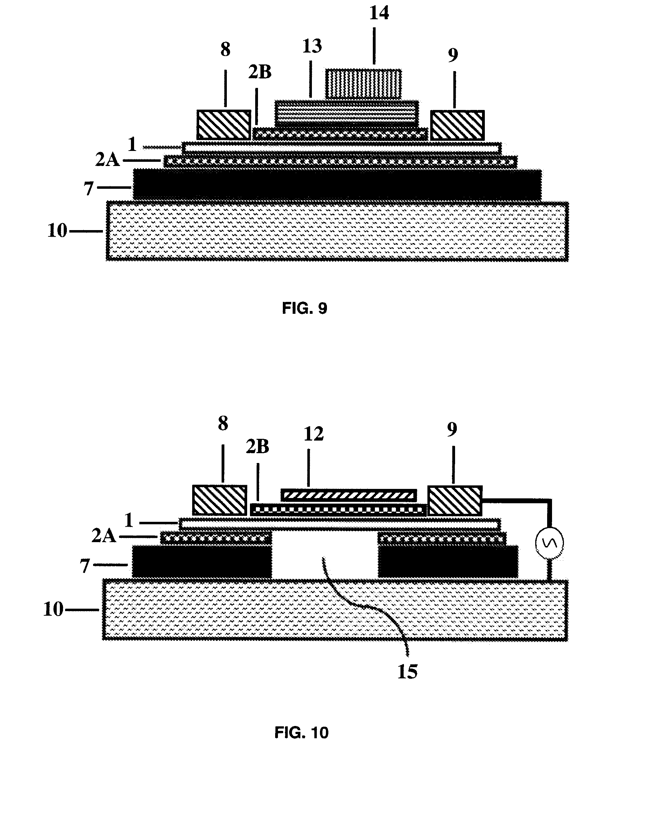

In another embodiment, there is provided a top-gated field effect device comprising the graphene structure (1) of the invention wherein the top basal plane of the graphene structure (1) is electrically contacted by separate source (8) and drain (9) electrodes. In this top-gated field effect device, the layer of molecules which functionalises the top basal plane is chosen such that the functional group on each molecule (6B) can enhance the growth of a continuous layer of an inorganic dielectric, e.g., by atomic layer deposition. The (top) gate electrode could then be defined, for example, using lithography, metal evaporation and liftoff. This is shown in the embodiment of FIG. 9.

According to a second aspect of the invention, there is provided a method for the manufacture of a graphene structure according to any of the preceding claims comprising
i) preparing and cleaning a substrate (7);
ii) depositing a layer of graphene (1) onto the substrate (7);
iii) reacting the substrate (7) from step (ii) with a functional organic molecule (3) comprising
   an anchor group (4) which has the ability to form a non-covalent bond with graphene,
   a functional group (6); and
   an alkyl-chain spacer group which separates the anchor group (4) and functional group (6) and facilitates the formation of a self-assembled monolayer (2) of functional organic molecules (3);
to result in the formation of a self-assembled monolayer (2) of one or more functional organic molecules (3) non-covalently bonded to the top and/or bottom basal plane of the graphene.

Optionally, the method may involve the step of pre-treating the substrate prior to step (ii) with the functional organic molecule (3). In this preferred embodiment, the cleaned substrate (7) is then functionalised with a layer of functional organic molecules (3) such that the functional group (6A) binds to the substrate and the anchor groups (4A) are available to bind graphene (1) when this is deposited onto the substrate. In this manner, pre-treatment of the substrate, (for example silicon oxide substrates with amine-bearing molecules) greatly increases the observed number density of monolayer graphene flakes and also increases the mean size of deposited flakes.

Ideally, the substrate is a silicon oxide substrate although other substrates may be used as expanded on above in relation to the first aspect of the invention.

It will be understood that the deposition of graphene may take place by mechanical exfoliation from graphite or by transfer of a graphene layer deposited or grown on another substrate.

The functional organic molecule may be diaminodecane, preferably 1,10-diaminodecane.

Ideally, the functional organic molecules (3) are deposited from solution or from the vapour phase.

According to a third aspect of the invention, there is provided a method for directed deposition of graphene onto a substrate (7) in accordance with the above method further comprising patterning, either by photolithography or by soft lithography, the self-assembled monolayer (2) of functional organic molecules (3) to result in pre-defined areas on the substrate (7) to enable the site-specific deposition of graphene (1) at the pre-defined areas on the substrate (7) in step (iii).

Essentially, this aspect of the present invention involves the functionalisation of a substrate surface with functional organic molecules which bear groups to which the graphene can bind (e.g., diaminodecane molecules on SiO₂). Directed deposition could then be achieved by patterning of the molecules, either by photolithography or by soft lithography methods (such as microcontact printing), followed by deposition of graphene, e.g., by mechanical exfoliation from graphite or by transfer of a graphene layer deposited or grown on another substrate.

Ideally, the functional organic molecule is an amine-bearing molecule, such as diaminodecane as described above.

Thus, the directed deposition of graphene on to a substrate (7) which has assemblies of the functional organic molecules (3) in certain regions ("patterns") leads to preferential deposition of graphene in these regions following graphene deposition, usually by exfoliation from graphite or transfer from a graphene-bearing substrate.

Ideally, the substrate is a silicon oxide substrate although other substrates may be used as expanded on above. As shown in FIG. 9, the molecular layer 2B is chosen such that molecules with specific functional head groups (6B), e.g. -OH, are chosen to promote binding of a dielectric deposited by atomic layer deposition, such as Al₂O₃ or HfO₂.

According to a fourth aspect of the invention, there is provided a method for the gas and/or liquid-phase sensing of target chemical or biological groups in a sample solution comprising the steps of
i) selecting a target moiety (11);
ii) modifying the graphene structure (1) of the invention such that the functional head group (6, 6B) is a bridging group which interacts with the target moiety (11);
iii) placing the modified graphene structure (1) of step (ii) in a biosensor
iv) contacting the biosensor with a sample solution; and
v) monitoring and/or recording the selective binding of the target moiety (11) to the functional head group (6, 6B) of the graphene structure (1).

In this aspect of the invention, the functional group is chosen to interact with the target moiety or group. The target moiety may be a nanocrystal; a biomolecule; or an ion. The biomolecule may be a nucleic acid (Ribonucleic acid (RNA), Deoxyribonucleic acid (DNA)), oligonucleotide, polymerase chain reaction (PCR) product, amino acid, antibody, antibody fragment, antigen, aptamer, enzyme, peptide, protein or a fragment thereof.

In one embodiment, the functional group interacts directly with the target moiety.

In another embodiment, the functional group interacts indirectly with the target moiety through a bridging group. For example, the bridging group may be phenylenedisothiocyanate (PDITC). PDITC is known to interact with DNA.

In this manner, the modified graphene of the invention may be used in molecular recognition to promote binding of specific moieties for chemo- or bio-sensing applications, either as conductivity-based sensors, resonators (mass sensors) or electrochemical sensors.

### Detailed Description of the Invention

The invention will be more clearly understood by the following description of some embodiments thereof, given by way of example only with reference to the accompanying Figures and Examples, in which:

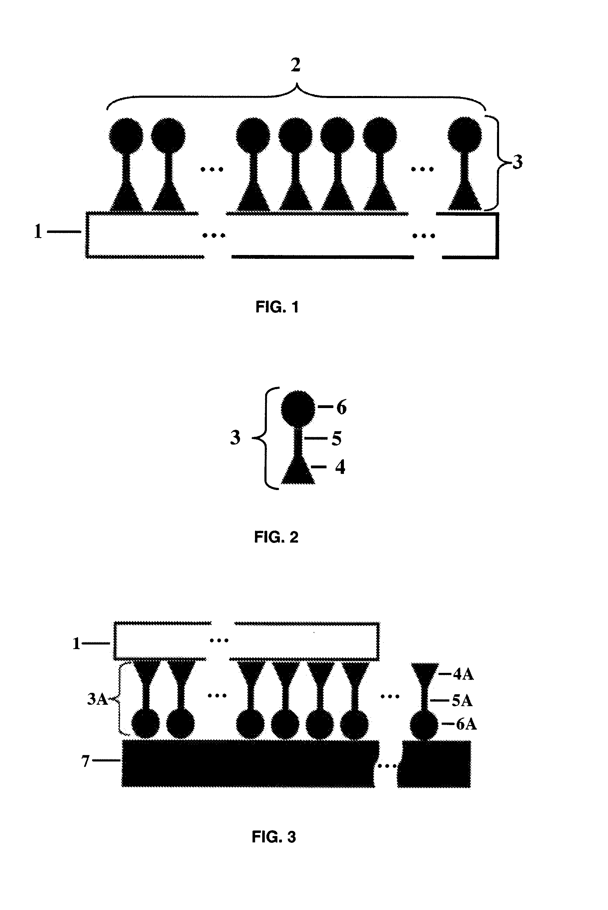

FIG. 1 shows a schematic side view showing a graphene crystal (1), of thickness between 1 and 10 atomic layers, where one basal plane is covered by a self-assembled monolayer (2) of functional organic molecules (3).
FIG. 2 shows a schematic of the modular functional organic molecule (3), which incorporates an anchor group (4), e.g. NH₂, for non-covalent attachment to graphene, an alkyl-chain spacer group (5), that contributes to the stabilisation of the self-assembled monolayer and controls the separation between the graphene layer and the functional head group on the molecule (6).
FIG. 3 shows a schematic side view showing a layer of molecules, where the functional head group on each molecule (6A) is chosen to promote binding of a graphene structure (1) to a specific substrate material (7). In some embodiments, the layer of molecules is first deposited on the substrate and the graphene sheet is then transferred, e.g., by exfoliation from graphite.
FIG. 4 shows a schematic side view showing a graphene structure (1), where one layer of molecules (type 3A) promotes binding to a specific substrate material (7) and another layer of molecules (type 3B) provides additional functionality; e.g., (top) surface passivation and/or adsorbate doping.
FIG. 5 shows a schematic side view showing a graphene structure (1), where only one surface has been modified with a layer (2B) of functional molecules (of type 3B).
FIG. 6 shows a schematic side view of a back-gated, graphene field-effect device, featuring a graphene structure (1), where the top basal plane is electrically contacted by separate source (8) and drain (9) electrodes. The exposed regions of the top surface are functionalised with a layer of molecules (2B). The graphene structure is located over a gate dielectric (7), which is electrically contacted by a gate electrode (10). A layer of molecules (2A) promotes binding of the graphene structure (1) to the gate dielectric (7).

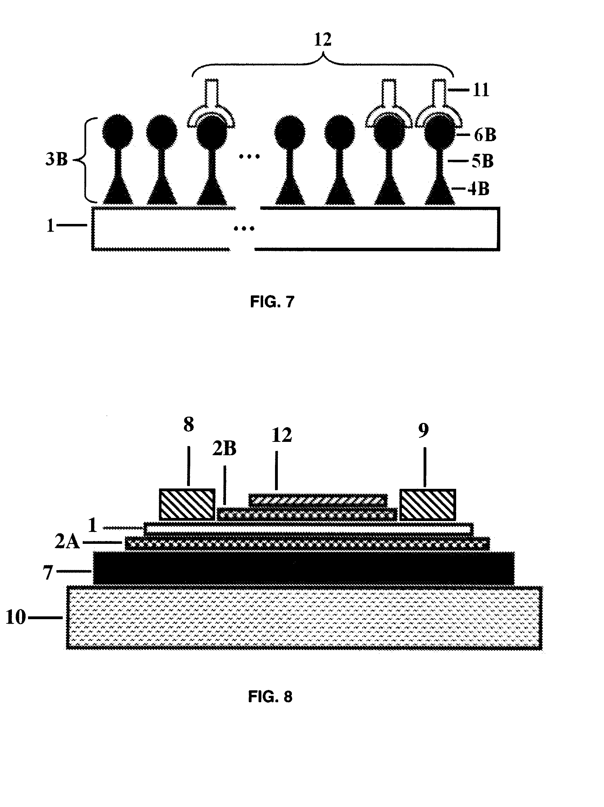

FIG. 7 shows the selective binding of a partial or full layer of target moieties (12), through tailoring of the functional head group (6B) to match the target moiety (11).
FIG. 8 shows a schematic of a conductance-based graphene sensor, where adsorption of a (partial) layer of target moieties (12) results in a change in conductance of the device.
FIG. 9 shows a schematic of a top-gated graphene field-effect device, where the molecular layer adsorbed on the top basal plane (2B) is chosen to promote growth of a high-quality top gate dielectric (13) with a low density of interface states. The conductance is modulated by application of a voltage to the top gate electrode (14).
FIG. 10 shows a cross-sectional schematic of an electromechanical resonator device based on a graphene structure (1) suspended over a trench (15) etched into a dielectric layer (7). The top surface of the graphene structure is functionalised with a layer of molecules (2B) to promote adsorption of a (partial) layer of specific target molecules (12) from the gas or liquid phase. The graphene structure can behave as a doubly-clamped beam or a singly-clamped cantilever and the suspended structure can be deformed by application of a direct (dc) or alternating (ac) voltage between the drain (9) and the gate (10) electrodes. The gate-drain capacitance can be monitored to quantify the deformation. If the structure is driven at its resonance frequency, then it can be used as a mass sensor. Binding of target moieties will cause an increase in the mass (and hence a decrease in the resonance frequency) of the structure and the drain-gate capacitance will be attenuated if the driving frequency no longer matches the resonance frequency.

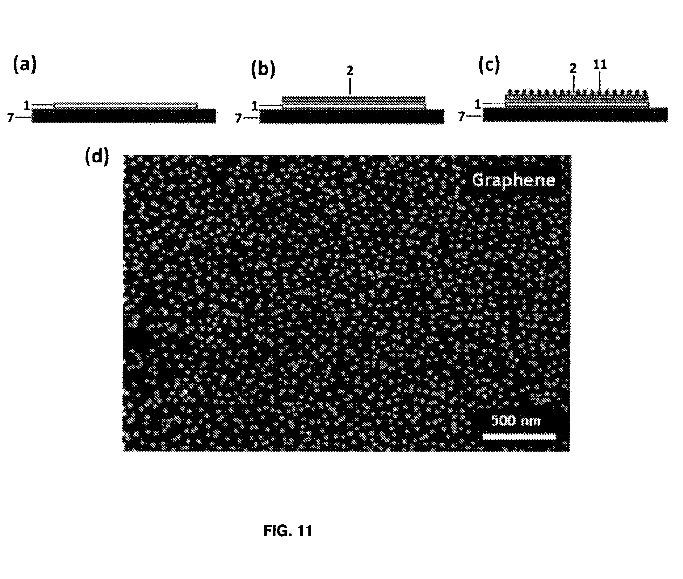

FIG. 11 shows a schematic of process for the functionalisation of graphene: (a) Graphene (1) on substrate (7); (b) functionalised with a layer of molecules (2) that can (c) bind gold nanoparticles (11); (d) Scanning electron microscope image showing a high surface density of citrate-stabilised gold nanoparticles (30 nm core diameter) bound to a layer of 1,10-diaminodecane molecules adsorbed on graphene as described in Example 2.

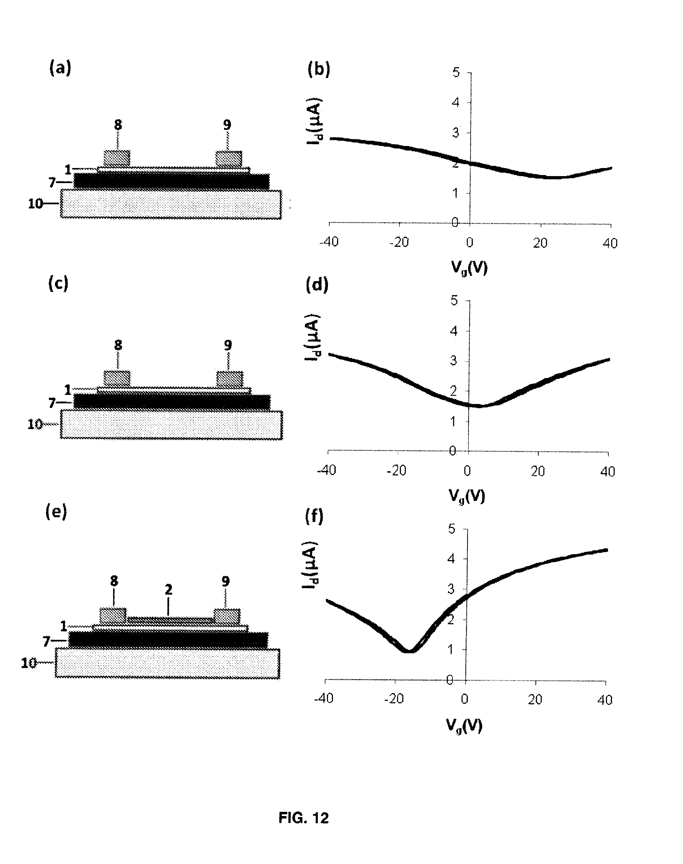

FIG. 12 shows the schematics of field effect devices of Example 3 and drain current vs gate voltage (*I*_{d}-*V*_{g}) measurements of same:
   (a) As-prepared field-effect device comprising a graphene layer (1) deposited on a thermally grown layer of silicon oxide (7) on a doped silicon substrate (10). The silicon substrate acts as a back-gate electrode for the device (b) I_{d}-V_{g} characteristics of a contacted graphene device of (a) measured in vacuum (10⁻⁶ mbar) showing minimum conductivity (Dirac Point) at positive gate voltage (*V*_{g} ~25 V in this case).
   (c) Schematic of an annealed field effect device (d) I_{d}-V_{g} characteristics of the same graphene device (c) (data shown in (b)), measured in vacuum (10⁻⁶ mbar) following annealing in vacuum (10⁻⁶ mbar) at 100 °C for 18 hours.
   (e) Schematic of a contacted graphene layer following adsorption of a layer of functional molecules (2) (f) I_{d}-V_{g} characteristics of the same graphene device (data shown in (b),(d)), following functionalisation in solution with 1,10-diaminodecane (device also measured in vacuum).

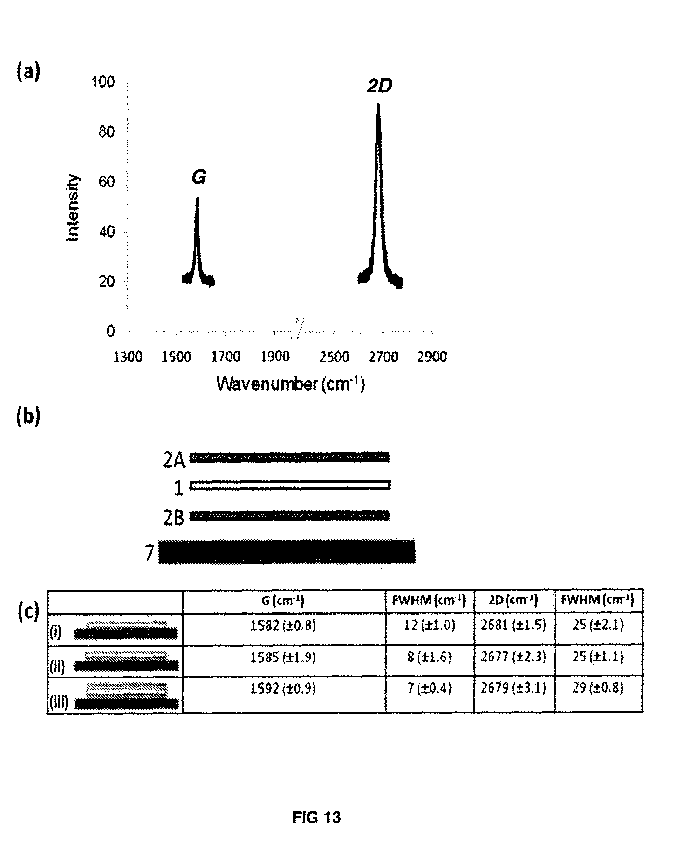

FIG 13 shows the results of Raman spectrum and data without chemical functionalisation and with chemical functionalisation below and/or above graphene sheets:
   (a) Typical Raman spectrum of a monolayer graphene sheet on a silicon oxide surface. Shown are the two most prominent and characteristic peaks of graphene, the G peak (centred close to 1582 cm⁻¹) and the 2D peak, (centred close to 2681 cm⁻¹), respectively .
   (b) Schematic highlighting a thermally oxidised silicon substrate (7), a molecular layer (2B) that modifies the substrate (7), a graphene sheet (1), and a molecular layer (2A) that modifies the top surface of 1.
   (c) Tabulation of specfic Raman results namely, the peak positions and full-width-at-half-maximum (FWHM) for the G and *2D* peaks, respectively. Data are reported for (i) graphene (1) deposited on bare silicon oxide (7), (ii) graphene (1) deposited on silicon oxide (7) modified with 1,10-diaminodecane, (iii) graphene (1) deposited on silicon oxide (7) modified with 1,10-diaminodecane, where the top surface of the graphene is subsequently modified with 1,10-diaminodecane. The data are averaged over multiple locations on different graphene sheets. Tabulated values represent the averages, values in parentheses represent the standard deviations.

Referring to FIG. 1, there is shown a schematic side view of graphene crystal (1), of thickness between 1 and 10 atomic layers, where one basal plane is covered by a self-assembled monolayer (2) of functional organic molecules (3).

As shown in both FIG. 1 and FIG. 2, these modular molecules (3) comprise an anchor group (4), a spacer group (5) and a functional head group (6). The anchor group (4), e.g. NH₂, is for non-covalent attachment to graphene, the alkyl-chain spacer group (5), contributes to the stabilisation of the self-assembled monolayer and controls the separation between the graphene layer and the functional head group on the molecule (6).

In most embodiments of the device, a suitable molecule (3A) with a specific functional head group (6A) is employed to promote deposition or transfer of graphene onto a particular substrate material (7). For example, 1,10-diaminodecane can be used to promote binding of graphene to SiO₂. Using patterning methods, e.g., optical lithography, electron-beam lithography or micro-contact printing (Whitesides et al. Patterning self-assembled monolayers - applications in materials science, Langmuir, 1994, 10, 1498) a layer of molecules can be patterned into a well-defined shape (or shapes) to promote site-specific deposition of graphene.

Referring in particular to FIG. 3, there is shown a schematic side view showing a layer of molecules, where the functional head group (6A) is chosen to promote binding of a graphene structure (1) to a specific substrate material (7).

It will be understood that most embodiments of the device feature graphene structures with layers of molecules non-covalently bound to both the top and bottom basal planes. This is shown in FIG. 4 where one layer of molecules (type 3A) promotes binding to a specific substrate material (7), and provides adsorbate doping via charge transfer. Another layer of molecules (type 3B) provides additional functionality e.g., (top) surface passivation and/or adsorbate doping and/or binding of target moieties. The large surface density of molecules (3B) on the top surface of the graphene is evidenced by SEM data showing a large areal density of citrate-stabilised gold nanoparticles bound to graphene structures functionalised with 1,10-diaminodecane (see FIG. 11). Patterning of these molecules can also be achieved, e.g. via microcontact printing.

As shown in FIG. 5, some embodiments of the device feature a graphene structure (1) where only one surface has been modified with a layer (2B) of functional molecules (of type 3B).

Referring in particular to FIG. 6, there is shown a schematic side view of a back-gated, graphene field-effect device, featuring a graphene structure (1), where the top basal plane is electrically contacted by separate source (8) and drain (9) electrodes. The exposed regions of the top surface are functionalised with a layer of molecules (2B). The graphene structure is located over a gate dielectric (7), which is electrically contacted by a gate electrode (10). A layer of molecules (2A) promotes binding of the graphene structure (1) to the gate dielectric (7).

The following passages relate to the use of the modified graphene in graphene-based electronic devices.

### Molecular passivation of field-effect devices

In another embodiment of the device, the exposed top basal plane of the graphene structure can be passivated by adsorption of a layer of molecules (2B). Several groups have reported fabrication of micron- and nanometre-scale back-gated graphene field-effect devices. (Novoselov et al, "Electric field effect in atomically thin carbon films" Science, 2004, 306, 666). None of these reports employed molecular layers on the top or bottom basal planes of the graphene structure. It is known that such graphene field-effect devices (without any adsorbed molecular layers) generally show minimum conduction (Dirac Point) at positive gate voltages, indicating hole doping, likely due to adsorbed oxygen on the graphene surface. (Lemme, MC et. al "A graphene field effect device" IEEE, 2007, 28, 282). Annealed devices show minimum conduction close to zero gate voltage, however shifts back to positive Dirac Points (and hysteretic behaviour) are routinely observed if the device is exposed to ambient conditions or water vapour. Inorganic passivation layers have been employed by a number of groups, however these layers often have a detrimental influence on carrier mobility. In this invention, molecular layers can be used to passivate exposed graphene surfaces. Conduction versus gate voltage measurements acquired for graphene field-effect devices where the top surface was passivated by a molecular layer (2B) following annealing, yielded reproducible conduction data over a period of several weeks for devices stored under ambient conditions. Examples of molecules (3B in FIG. 5) include 1-aminohexane (C₆H₁₅N, with 4B = NH₂ and 6B = CH₃), 1-aminodecane (C₁₀H₂₃N, with 4B = NH₂ and 6B = CH₃) and 1,10-diaminodecane (C₁₀H₂₄N₂ with 4B = NH₂, 6B = NH₂). These devices were fabricated by direct deposition of graphene onto a SiO₂ dielectric layer (i.e. no 2A layer present).

### Adsorbate doping of graphene field-effect devices

Controlled adsorbate doping can be achieved by selection of appropriate molecules (3A, 3B); e.g., n-type adsorbate doping for 3B = 1-aminohexane, 1-aminodecane or 1,10-diaminodecane.

FIG. 7 shows the selective binding of a partial or full layer of target moieties (12), through tailoring of the functional head group (6B) to match the target (11).

### Gas- or liquid-phase sensing of target chemical or biological moieties via selective binding to probe molecules assembled on graphene structures.

By choosing an appropriate head group (6B in FIG. 7), target chemical or biological moieties can be attached to graphene.

### Conductance-based Sensor

Referring to FIG. 8, there is shown an embodiment of a conductance-based field-effect sensor, where adsorption of a (partial) layer of target moieties (12) results in a change in conductance of the device (or shift in the Dirac point).

### Top Gated Device

FIG. 9 shows an embodiment of a top-gated device. Specifically, FIG. 9 shows a schematic of a top-gated graphene field-effect device, where the molecular layer adsorbed on the top basal plane (2B) is chosen to promote growth of a high-quality top gate dielectric (13) with a low density of interface states for example, choice of a layer (2B) where the functional group on each molecule (6B) contains an hydroxy (-OH) group, would enable growth of an aluminium oxide or hafnium dioxide dielectric by atomic layer deposition. The conductance could be modulated by application of a voltage to the top gate electrode (14).

### Mass sensor (resonator structure)

Referring to FIG. 10, there is shown a cross-sectional schematic of an electromechanical resonator device based on a graphene structure (1) suspended over a trench (15) etched into a dielectric layer (7). Several groups have reported fabrication of graphene-based electromechanical resonators devices using a graphene structure (1) suspended over a trench (15) etched into a dielectric layer (7).

The top surface of the graphene structure is functionalised with a layer of molecules (2B) to promote adsorption of a (partial) layer of specific target molecules (12) from the gas or liquid phase. The graphene structure can behave as a doubly-clamped beam or a singly-clamped cantilever and the suspended structure can be deformed by application of a direct (dc) or alternating (ac) voltage between the drain (9) and the gate (10) electrodes. The gate-drain capacitance can be monitored to quantify the deformation. If the structure is driven at its resonance frequency, then it can be used as a mass sensor. Binding of target moieties will cause an increase in the mass (and hence a decrease in the resonance frequency) of the structure and the drain-gate capacitance will be attenuated if the driving frequency no longer matches the resonance frequency.

### Example 1

### Graphene deposition and functionalisation

### Materials

n-doped silicon wafers were purchased from SVM Silicon Valley Microelectronics Inc, USA. Polymer resist (Shipley S1813) and Microposit resist remover (R1165) were purchased from Chestech, UK.

Aqueous solutions of citrate-stabilised gold nanoparticles were purchased from British Biocell International. UK. Three separate families of nanoparticles with different core diameters (*d*_{NP}) and concentrations (*C*_{NP}) were employed for different functionalisation experiments:
*d*_{NP} =30 nm, *C*_{NP} = 2.0×10¹¹ nanoparticles/ mL
*d*_{NP} =20 nm, *C*_{NP} = 7.0×10¹¹ nanoparticles/ mL
*d*_{NP} =10 nm, *C*_{NP} = 5.7×10¹² nanoparticles/mL

1,10-diaminodecane, 1-aminodecane, 1-aminohexane, methanol and tetrahydrofuran were purchased from Sigma-Aldrich, UK.

### Full Method Protocol

### 1. Substrate preparation and cleaning

90 nm of silicon oxide was thermally grown on commercial n-doped silicon wafers using dry oxidation. The rear surface of the wafer was stripped of the oxide to enable its use as a back gate. Arrays of binary alignment marks were patterned into the oxide by photolithography, metal evaporation (Ti 5 nm, Au 30 nm) and liftoff. Following spin-coating with a protective polymer photoresist layer (Shipley S1813), wafers were diced into individual die. Following dicing, the resist was then dissolved from the surface using a resist-removing solvent (R1165). The R1165 was heated to 80°C prior to immersing the substrate. The substrate was immersed for 5 minutes then transferred to a container, which contained R1165 at room temperature. Following immersion in this solution for 30 seconds, the substrate was dipped in ultrapure de-ionised water (resistivity 18 MΩ.cm) for 10 seconds and dried under a stream of nitrogen.

### 2. Graphene deposition onto untreated silicon oxide chips of Step 1

Micromechanical cleavage was then employed to deposit graphene on oxidised silicon substrates prepared in Step 1. This process first involved removing a thin layer of graphite from a "*slate-like*" portion (∼2 cm by 2 cm) of natural graphite. Adhesive tape was placed across the graphite and gently peeled back leaving a graphite film on the tape. Another piece of adhesive tape was used to peel back a thin layer from the "mother-tape". This was then applied to the oxidised silicon substrates of Step 1 and left in position while heating the substrate to 40°C for a minimum of 1 hour. The tape was then gently peeled back, leaving portions of graphene adhering to the substrate.

### 3. Preparation of 10 mM solutions of 1,10-diaminodecane, 1-aminodecane, 1-aminohexane and 1 mM solution of 1,10-diaminodecane.

172 mg of 1,10-diaminodecane (molecular weight 172 gL⁻¹) was dissolved in methanol:tetrahydrofuran in a 1:10 ratio (total volume 100 mL) yielding a 10 mM solution. 17.2 mg 1,10-diaminodecane (molecular weight 172 gL⁻¹) was dissolved in methanol:tetrahydrofuran in a 1:10 ratio (total volume 100 mL) yielding a 1 mM solution. 157 mg of 1-aminodecane (molecular weight 157 gL⁻¹) was dissolved in methanol:tetrahydrofuran in a 1:10 ratio (total volume 100 mL) yielding a 10 mM solution. 101 mg of 1-aminohexane (molecular weight 101 gL⁻¹) was dissolved in methanol:tetrahydrofuran in a 1:10 ratio (total volume 100 mL) yielding a 10 mM solution.

### 4. Pre-treatment modification of silicon oxide substrate with 1.10-diaminodecane

The oxidised silicon substrates prepared and cleaned in Step 1 were immersed in a 10 mM solution of 1,10-diaminodecane for a period of three hours. Each substrate was then rinsed in the same solvent mixture (1:10 methanol:tetrahydrofuran) to remove excess 1,10-diaminodecane and dried under a stream of nitrogen.

### 5. Graphene deposition on modified silicon oxide substrates

Micromechanical cleavage was then employed to deposit graphene on the treated silicon oxide substrates of Step 4, using the same process steps described in Step 2. This process first involved removing a thin layer of graphite from a "*slate-like*" portion (∼2 cm by 2 cm) of natural graphite. Adhesive tape was placed across the graphite and gently peeled back leaving a graphite film on the tape. Another piece of adhesive tape was used to peel back a thin layer from the "mother-tape". This was then applied to a treated substrate of Step 4 and left in position while heating the substrate to 40°C for a minimum of 1 hour. The tape was then gently peeled back, leaving portions of graphene adhering to the substrate; as depicted in FIG. 3.

The above method protocols (Steps 2 and 5) resulted in two types of silicon oxide chips
i) an untreated silicon oxide chip with deposited graphene; and
ii) a pre-treated silicon oxide chip with deposited graphene.

### 6. Optical Inspection and Raman Spectroscopy Measurements on Graphene

All graphene-bearing chips (i and ii) were inspected using optical microscopy (Zeiss Axioscop II, 100x lens) under white light illumination. The layer thickness of each graphene flake was estimated using analysis of recorded greyscale images to determine the contrast between the substrate and the graphene layer. In this manner, both monolayer and bilayer graphene sheets could be readily identified. These estimates were validated by Raman Spectroscopy measurements on the same graphene sheets. These Raman measurements were carried out on a confocal Raman microscope (Jobin Yvon T6400) with a triple monochromator using laser excitation at 514 nm and an incident power of 0.7 ― 0.8 mW for an energy range from 1000 cm⁻¹ ― 3500 cm⁻¹ to investigate, record and analyse the peak intensities, positions (intensity maximum) and line shapes for various graphene peaks, including the G, D, D', G*, 2D and 2D' peaks.

### 7. Graphene Functionalisation

Chips (i and ii) bearing graphene sheets were immersed in a 10 mM solution of 1,10-diaminodecane for 24 hours. Each chip was then rinsed in the same solvent mixture (1:10 methanol:tetrahydrofuran) to remove excess 1,10-diaminodecane and dried under a stream of nitrogen.

### Results & Conclusion

Two types of silicon oxide chips were manufactured (Steps 2 and 5):
i) a functionalised untreated silicon oxide chip with deposited graphene; and
ii) a functionalised pre-treated silicon oxide chip with deposited graphene.

We found that pre-treatment (i.e. chip (ii)) of SiO₂ surfaces with amine-bearing molecules prior to graphene deposition greatly increases the observed number density of monolayer graphene flakes and also increases the mean size of deposited monolayer flakes.

We found that a threshold concentration of >1 mM 1,10-diaminodecane is required for functionalisation of graphene surfaces. Low concentrations i.e. ≤1 mM resulted in poor surface coverage as evidenced by subsequent experiments targeting attachment of gold nanoparticles (see Example 2).

In addition, this functionalisation method shows potential for development of directed deposition methods for site-specific deposition of graphene at defined locations on substrate surfaces.

### Example 2

### Functionalisation of graphene with gold nanoparticles

Silicon oxide chips bearing graphene sheets, where the top surface of graphene was functionalised with 1,10-diaminodecane made in accordance with Example 1 were immersed in a solution of citrate-stabilised gold nanoparticles (30 nm core diameter) for 6 hours. The chip was then removed and rinsed in ultra pure water before drying under a stream of nitrogen. Scanning electron microscopy (JEOL 6700F, 10 kV beam voltage) was employed to image and record the number density of nanoparticles present at the surfaces of these functionalised monolayer graphene sheets.

FIG. 11 shows a schematic of process for the functionalisation of graphene: (a) Graphene (1) on substrate (7); (b) functionalised with a layer of molecules (2) that can (c) bind gold nanoparticles (11).

### Results

FIG. 11 (d) is a scanning electron microscope image showing a high surface density of citrate-stabilised gold nanoparticles (30 nm core diameter) bound to a graphene layer on a silicon oxide substrate, where the top surface of the graphene had previously been functionalised with a layer of 1,10-diaminodecane molecules. These results show that graphene sheets functionalised as described in Example 1 Step 7 (i.e. with 1,10-diaminodecane) showed high surface densities of nanoparticles (∼290 nanoparticles per µm²; FIG. 11 d).

Control measurements were performed to demonstrate that the nanoparticle surface density indicated a high density of binding functional head groups. Graphene-bearing chips were functionalised with aminohexane and immersed in nanoparticle solutions for 6 hours, then rinsed and dried. Since the aminohexane only features one amine group (which is expected to bind to graphene), the functional group on these molecules would be a methyl group, which does not promote binding of gold nanoparticles. SEM measurements revealed significantly lower surface densities of nanoparticles on these aminohexane-functionalised graphene sheets (∼5 nanoparticles per µm²). Additional control measurements on untreated graphene-bearing chips also revealed low surface densities of nanoparticles (~1 nanoparticle per µm²).

### Conclusion

Thus, we have discovered that the surface density of citrate-stabilised gold nanoparticles attached to the treated graphene layers was substantially higher than for untreated graphene. The high density of these charge-stabilised gold nanoparticles suggested a high density of 1,10 diaminodecane present on the graphene sheets.

### Example 3

### Preparation of graphene field effect devices

A number of field effect devices were fabricated and measured as shown in FIG. 12 (a), (c), and (e).
- FIG. 12(a) is a field-effect device comprising a graphene layer (1) deposited on a clean thermally-grown layer of silicon oxide (7) on a doped silicon substrate (10). The silicon substrate acts as a back-gate electrode for the device.
- FIG. 12(c) is a schematic of the same graphene field effect device following annealing in vacuum.
- FIG. 12(e) is a schematic the same graphene field effect device following adsorption of a layer of functional molecules onto the graphene by immersion in a solution of 1,10-diaminodecane in methanol-tetrahydrofuran.

### Field effect device (FIG. 12(a))

a. Graphene sheets deposited on oxidised silicon chips were electrically contacted with nickel electrodes using standard optical lithography, metal deposition and lift-off procedures.

After the deposition of the graphene by mechanical exfoliation, a suitable graphene sheet was identified with an optical microscope by contrast measurement of the graphene on the SiO₂ substrate. To fabricate the source and drain electrical contacts to this graphene sheet, a film of LOR 3A photoresist was spun-cast onto the graphene-bearing substrate at a spin speed of 3000 revolutions per minute (RPM) and baked at 180 °C for 120 seconds on a hotplate. Subsequently a film of UVN30 resist was spun on (4000 RPM) and baked out at 92 °C for 60 seconds on a hotplate. The resist was exposed to UV light using a contact mask. After exposure, the sample was baked for 60 seconds on a 92 °C hotplate in a post exposure bake. Then, the resist was developed in MF26A for 30 seconds and rinsed in deionised water to remove the resist in regions corresponding to the required electrode pattern. The graphene bearing-substrate with the lithographically patterned lift-off mask was sputtered with 40 nm of nickel. The excess metal located on top of the remaining (unexposed) resist was removed in an acetone lift-off process leaving the metallised contact structure on the graphene-bearing substrate. Finally, the residual LOR 3A was removed using MF26A developer, rinsed in deionised water and propanol and blown dry with nitrogen.

### Measurement of graphene field-effect devices

The current voltage characteristics of a graphene field effect device schematically depicted in FIG. 12a were measured under vacuum in a four probe station (Desert Cryogenics TTP4) interfaced to a semiconductor parameter analyser (HP 4156A). The graphene field effect devices were loaded into the chamber of the probe station, which was then pumped down to ~ 10⁻⁶ mbar. The nickel probe pads, which were connected to the electrode structure contacting the graphene flake were contacted with the probes. The source-drain voltage was set at 20 mV. The back-gate voltage was swept from 0 V → 40 V → 0 V → -40 V → 0 V in steps of 1 V and the source, drain and gate currents were measured at each gate voltage step (see FIG. 12b for drain current vs gate voltage data).

### Field effect device following annealing in vacuum (FIG. 12(c))

Following repeated measurements, the device was annealed (without breaking vacuum) to 100 °C for 18 hours, then cooled to room temperature and the electrical characteristics were re-measured as described above (see FIG. 12d for drain current vs gate voltage data).

### Field effect device following functionalisation in solution with 1,10-diaminodecane in vacuum (FIG. 12(e))

The probe station chamber was vented with dry nitrogen gas and the device was removed and immersed in a 10 mM solution of 1,10-diaminodecane in methanol-tetrahydrofuran for 24 hours. Following rinsing in methanol-THF, the device was reloaded into the probe station chamber. The chamber was pumped down to ~ 10⁻⁶ mbar and the electrical characteristics were re-measured as described above (see FIG. 12f for drain current vs gate voltage data).

### Results

This example shows the influence of processing and functionalisation on the electrical characteristics of a graphene field-effect device at 3 stages:
1. After fabrication (ie lithographic patterning of metal contacts onto the graphene sheet, which had been deposited on an oxidised silicon substrate) (FIG. 12 (b)). FIG. 12 (b) shows the I_{d}-V_{g} characteristics of a contacted graphene device of (a) showing minimum conductivity (Dirac Point) at positive gate voltage (*V*_{g} ~ 25 V in this case).
2. After annealing this device in vacuum, i.e. immediately after Stage 1 and without removing the device from the vacuum chamber (FIG. 12 (d)). FIG. 12 (d) shows the I_{d}**-**V_{g} characteristics of the same graphene device (c) (data shown in (b)), following annealing in vacuum.
3. After removing the device from the chamber following Stage 2, immersing it in 1,10-diaminodecane then loading it into the chamber, evacuating the chamber and measuring the device characteristics vacuum (FIG. 12 (e)). FIG. 12 (f) shows the I_{d}-V_{g} characteristics of the same graphene device (data shown in (b),(d)), following functionalisation in solution with 1,10-diaminodecane.

Initial measurements on as-fabricated devices showed that the gate voltage which corresponded to minimum conductivity (Dirac Point) occurred at positive gate voltages (FIG. 12 (b)). The Dirac Point voltage (*V*_{DP}) varied from device to device. This is accepted to be a result of adsorption of H₂O/O₂ and variance in this value is dependent on the age of the device and its level of exposure to the ambient environment. A temporary solution to this source of instability is to heat (anneal) the device for a period of time (FIG. 12 (d)), thus shifting the Dirac Point to approximately 0 V gate bias. However, within a short time scale (hours) the Dirac Point shifts towards positive gate voltages again. Employing graphene functionalisation, we found a shift to negative voltages of the point of minimum conductivity, suggesting n-type doping. Most importantly, the drain current vs gate voltage characteristics show low hysteresis and are stable. Measured devices showed similar characteristics (ie consistent values for the Dirac Point) even after months of storage in an ambient environment.

The electronic structure of graphene is captured by Raman spectroscopy. Raman is a nondestructive method which can identify the number of graphene layers (up to 5 layers) in a particular sheet by analysing various spectroscopic signatures, including what are referred to as the G peak (centred close to 1582 cm⁻¹) and the 2D peak (centred close to 2681 cm⁻¹) peaks. More importantly, the peak position and full-width-at-half-maximum intensity (FWHM) of these peaks are a tool to identify the chemical doping status of the graphene sheets. FIG. 13 highlights typical peak shifts for graphene deposited on a substrate with 1,10 diaminodecane below and/or above the graphene sheet and for graphene sheets in the absence of any chemical functionalisation.

FIG. 13(a) is a typical Raman spectrum of graphene deposited on a clean silicon oxide surface. Shown are the two most prominent and characteristic peaks of graphene, the G peak centred close to 1582 cm⁻¹ and the 2D peak centred close to 2681 cm⁻¹.

FIG. 13(b) is a schematic depicting a silicon oxide substrate (7), a molecular layer (2B) that modifies the substrate (7), a graphene sheet (1), and a molecular layer (2A) that modifies the top surface of 1.

FIG. 13(c) is a tabulation of specific Raman results, namely the peak positions and full-width-at-half-maximum (FWHM) for the G and 2D peaks, respectively. Data are reported for (i) graphene (1) deposited on bare silicon oxide (7), (ii) graphene (1) deposited on silicon oxide (7) modified with 1,10-diaminodecane, (iii) graphene (1) deposited on silicon oxide (7) modified with 1,10-diaminodecane, where the top surface of the graphene is subsequently modified with 1,10-diaminodecane. The data are averaged over multiple locations on different graphene sheets. Tabulated values represent the averages, values in parentheses represent the standard deviations.

Preliminary results from quantum chemistry modelling of an methylamine molecule on pyrene using second-order, many-body perturbation theory suggest that the amine anchor group non-covalently interacts with the pyrene surface with a binding energy on the order of 220 meV. Preliminary results from atomistic molecular dynamics simulations on assemblies of aminodecane molecules on graphene indicate formation of a self-assembled monolayer with mean nearest-neighbour separations of the amine anchor groups on the order of 0.33 nm.

### GENERAL CONCLUSIONS

It is well know that the propensity for graphene's basal plane to adsorb ambient matter (*e.g*., O₂ and H₂O) is to date a fundamental challenge that must be solved in order to make graphene useful as a device material. For field-effect devices, interim passivation solutions have recently been reported, based on deposition of polymer layers (- 10 nm thick) onto the exposed basal plane of the graphene sheet employed as the channel, followed by growth of inorganic dielectrics by atomic layer deposition.

We now postulate that the choice of suitable molecules, preferably amine-modified molecules, for formation of self-assembled monolayers on graphene sheets could provide improved process routes for passivation and/or functionalisation of the basal plane of the graphene surface leading to new applications involving graphene interconnects, field-effect devices, conductance-based sensor devices and electromechanical devices.

The invention is not limited to the embodiments hereinbefore described which may be varied in both construction and detail.

## Claims

1. A stable modified graphene structure comprising
a graphene sheet (1) and a self-assembled monolayer (2) of functional organic molecules (3) non-covalently bonded to the top and/or bottom basal planes of the graphene sheet wherein each functional organic molecule (3) comprises
an anchor group (4) which forms a non-covalent bond with the graphene;
a functional group (6); and
an alkyl-chain spacer group (5) which separates the anchor group (4) and functional group (6) and facilitates the self-assembly and stabilisation of the monolayer (2).

2. The graphene structure according to claim 1 deposited on a substrate (7), preferably a silicon oxide substrate.

3. A graphene structure according to claim 1 or claim 2 comprising a first layer of functional organic molecules (3) non-covalently bound to the bottom basal plane of the graphene and a second layer of functional organic molecules (3) non-covalently bound to the top basal planes of the graphene; wherein the first layer of functional organic molecules (3A) promotes binding to a substrate material (7), and the second layer of functional organic molecules (3B) provides additional functionality.

4. The graphene structure according to claim 3 wherein the additional functionality provided by the second layer of functional organic molecules (3B) includes surface passivation and/or adsorbate doping.

5. The graphene structure according to any of the preceding claims wherein the alkyl-chain spacer group comprises from 6 to 18 carbon atoms.

6. The graphene structure according to any of the preceding claims wherein the anchor group (4) is selected from an amine, alcohol, aniline, carboxylic acid, thiol, halide, pyridine, nitro, nitrile group or a derivative thereof.

7. The graphene structure according to any of the preceding claims wherein the functional group (6) is selected from a methyl, an amine, a thiol, a hydroxy, a carboxylic acid, a nitro, a silane group or a derivative thereof.

8. The graphene structure according to any of claims 1 to 7 wherein the functional group (6, 6B) interacts directly with a target moiety (11); or indirectly with a target moiety (11) through a bridging group, such as phenylenedisothiocyanate (PDITC).

9. The graphene structure according to claim 8 wherein the target moiety (11) is a nanocrystal; a biomolecule such as a nucleic acid, peptide or protein; or an ion.

10. The graphene structure according to any of the preceding claims wherein the functional organic molecule (3) is an amine-terminated molecule, preferably 1-aminodecane or 1,10-diaminodecane.

11. A field-effect device comprising the graphene structure (1) according to any of the preceding claims wherein the top basal plane of the graphene structure (1) is electrically contacted by separate source (8) and drain (9) electrodes, the graphene structure (1) is located over a gate dielectric (7), which is electrically contacted by a gate electrode (10) such that the exposed regions of the top basal plane are functionalised with a layer of molecules (2B) and optionally comprise a layer of molecules (2A), which promotes binding of the graphene structure (1) to the gate dielectric (7).

12. A method for the manufacture of a graphene structure according to any of the preceding claims comprising
i) preparing and cleaning a substrate (7);
ii) depositing a layer of graphene (1) onto the substrate (7);
iii) reacting the substrate (7) from step (ii) with a functional organic molecule (3) comprising
an anchor group (4) which has the ability to form a non-covalent bond with graphene,
a functional group (6); and
an alkyl-chain spacer group which separates the anchor group (4) and functional group (6) and facilitates the formation of a self-assembled monolayer (2) of functional organic molecules (3);
to result in the formation of a self-assembled monolayer (2) of one or more functional organic molecules (3) non-covalently bonded to the top and/or bottom basal plane of the graphene.

13. The method according to claim 12 comprising the optional step of pre-treating the substrate prior to step (ii) with the functional organic molecule (3).

14. A method for directed deposition of graphene onto a substrate (7) according to claim 12 or claim 13 comprising patterning, either by photolithography or by soft lithography, the self-assembled monolayer (2) of functional organic molecules (3) to result in pre-defined areas on the substrate (7) to enable the site-specific deposition of graphene (1) at the pre-defined areas on the substrate (7) in step (iii).

15. A method for the gas and/or liquid-phase sensing of target chemical or biological groups in a sample solution or vapour comprising the steps of
i) selecting a target moeity (11);
ii) selecting the functional head group (6, 6B) of a graphene structure (1) according to any of claims 1 to 12 or made according to claims 12 to 14 to selectively bind the target moiety (11);
iii) placing the modified graphene structure (1) of step (ii) in a biosensor
iv) exposing the biosensor to a sample solution or vapour; and
v) monitoring and/or recording the selective binding of the target moeity (11) to the functional head group (6, 6B) of the graphene structure (1).
